# EUROPEAN PATENT APPLICATION

(11) **EP 2 048 696 A2**
(43) Date of publication of application: **15.04.2009**
(21) Application number: 08165601.9
(22) Date of filing: 01.10.2008
(51) Int. Cl.: H01L 21/00

(54) **Process for manufacturing silicon wafers for solar cell**

(30) Priority: 08.10.2007 CN 200710132842
(71) Applicant: CSI Cells Co. Ltd., Suzhou New District Suzhou Jiangsu 215-123 (CN)
(72) Inventor: Chen, Genmao, 215123, Suzhou (CN); Peng, Jiang, 215123, Suzhou (CN)
(74) Representative: Lermer, Christoph

(57) **Abstract**

This invention discloses a process for manufacturing silicon wafers for solar cell, first break the refined metallurgical silicon, remove visible impurities, do chemical cleaning and then put them into crystal growing furnace, and at the same time, add gallium or gallium phosphide to the raw materials of silicon where the concentration of gallium atoms should be in the range from 5 ppma to 14 ppma, do subdivision and inspection after the crystal rods or crystal bars have grown, thus get the silicon wafers needed. With this solution, the refined metallurgical silicon can be used for manufacturing of solar cells, so as to reduce the cost of materials, and it is conducive to the universal application of silicon solar cells.

## Description

### Technical Field

This invention relates to a process for manufacturing silicon wafers for solar cell, and more particularly to a process for manufacturing low cost silicon wafers for solar cell with refined metallurgical silicon.

### Background of the invention

With the development of modem industry, energy demand is growing. As conventional energy sources will release a lot of carbon dioxide when being used, resulting in the global "greenhouse effect", countries around the world are trying to shake off the dependence on conventional energy sources and accelerate the development of renewable energy. As one of the best renewable energy sources, the use of solar energy has drawn high attention. Although the research on solar cells has been going on for 30 to 40 years, yet only in recent years have solar cells been put into large-scale applications. The rapid development of solar energy industry has greatly reduced its manufacturing costs, but at the same time, the cost of silicon materials for solar cell is rising rapidly, which makes the overall cost of application of solar cells is still high.

The purity of conventional silicon material for making solar cells should be more than 7N, leading to a high cost on material. How to manufacture solar cells using silicon wafers with lower purity becomes a focus of researches. The cost of refined metallurgical silicon is relatively low, but the impurity content of phosphorus and boron are comparatively high, so when this material is used for making solar cells, the boron, as an acceptor impurity, would make the silicon wafer to appear a P-type when the contents of boron is too high, and on other hand, when the content of phosphorus which is a donor impurity is high, the silicon will appear to be N-type. As the segregation coefficient of boron in silicon is 0.8 while that of phosphorus is 0.33, boron would be distributed evenly in the silicon after the crystal growing is finished. However, the distribution of phosphorus will be at high levels in the back-end of silicon rods (bars) which makes the silicon rods (bars) showing a reversed type in the back-end. And therefore this portion of material can not be used for making solar cells, which results in a low utilization of material.

If the type-reversing point can be made to be nearer to the end of silicon rods (bars) during the course of growth of crystal, that is, to increase the utilization of material, then it will greatly reduce the material cost of solar cell.

### Contents of the invention

In order to solve said problems, the object of the present invention is to provide a process for manufacturing low-cost silicon wafers for solar cells, which improves the utilization ratio of the length of the silicon crystal rods (bars) through reprocessing of the refined metallurgical silicon, so as to reduce the material cost of solar cells.

This object is achieved according to the technical solution described below:

A process for manufacturing silicon wafers for solar cell, first break the refined metallurgical silicon which has relatively high contents of phosphorus and boron, remove visible impurities (such as interlayer impurities), do chemical cleaning and then put them into crystal growing furnace, and at the same time, add gallium or gallium phosphide to the raw materials of silicon where the concentration of gallium atoms should be in the range from 5 ppma to 14 ppma, do subdivision and inspection after the crystal rods or crystal bars have grown, thus get the silicon wafers needed.

In which, the step of breaking the refined metallurgical silicon and removing impurities are existing skills which including the following typical steps: ①sorting and removing impurities visible to the unaided eye; □ultrasonic cleaning; □chemical cleaning (cleaning in the mixture of nitric acid and hydrofluoric acid to remove the surface impurities that may be contained). The step of the growth of crystal rods (bars) include heating it in the crucible with argon shield, when the temperature exceeds the melting point of silicon at 1412 °C, silicon is melting, and in this process, gallium is evenly spread to the melting liquid of silicon. Because the segregation coefficient of gallium in silicon is 0.008, the impact of concentration of gallium as impurity to the front end of crystal rods (bars) can be negligible, but in the back end of crystal rods (bars) it shows an exponential increase, and because gallium is an acceptor impurity like the boron, and therefore, the increase of gallium can compensate the impact due to high concentration of phosphorus at the back end of crystal rods (bars), making the type reversing point of crystal rods (bars) shift to the back end and thereby improves the utilization rate of crystal rods (bars).

According to the different requirement of the production of solar cells, said crystal rods growth may be pulling of silicon crystals process and the wafer obtained would be mono-crystalline silicon wafer.

Or, said crystal rods growth may be polycrystalline silicon casting process and the wafer obtained would be polycrystalline silicon wafer.

Said manufacturing processes of mono-crystalline silicon and polycrystalline silicon are both existing technologies.

With using of the above technology, this invention has the following effects compared with the background technologies:

In this invention, the gallium which has lower segregation coefficient in silicon but can act as acceptor impurity as boron is added in the silicon crystal before the silicon rod (bar) is grown, so that it reduces the tendency that the donor impurity would increase rapidly at the back end of the rod (bar), which makes the type reversing point shift to the very end of crystal silicon rod (bar), and finally improves the utilization of material. Therefore, the refined metallurgical silicon (5∼6 N) can be used for manufacturing of solar cells, reaching a higher material utilization and reducing the cost of materials, and it is conducive to the universal application of silicon solar cells.

### Description of the drawings

FIG. 1 is the process flow diagram of Example 1 of this invention;
FIG. 2 is the distribution diagram of net impurity concentration after gallium is added to the mono-crystalline silicon in Example 1, (The dotted line pointing to 0.68 refers to the type reversing point);
FIG 3 is the distribution diagram of net impurity concentration without gallium being added to the mono-crystalline silicon in Comparison Example 1. (The dotted line pointing to 0.61 refers to the type reversing point).

### Description of example embodiments

This invention will be best understood with reference to the following description of example embodiments:

### Example 1:

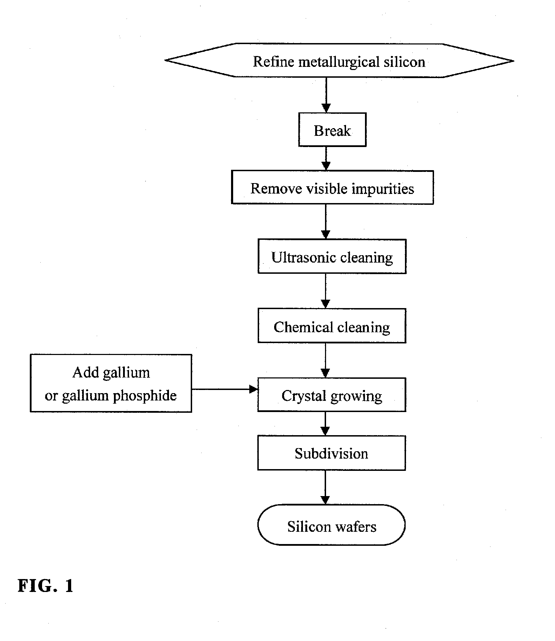

According to the drawing FIG. 1, a process for manufacturing silicon wafers for solar cell, first break the refined metallurgical silicon to the appropriate size, (if the incoming materials have high interlayer impurities, then the diameter of silicon pieces after breaking should be not more than 4 cm), then after preliminary selection to remove visible impurities, put them into ultrasonic cleaner for cleaning, move into mixture of nitric acid and hydrofluoric acid in order to wash away the surface impurities, and then put them into high-purity quartz crucible, and add gallium with atomic concentration of 12.0 ppma, then put the quartz crystal crucible into the graphite crucible in crystal furnace, and then pump the furnace into vacuum, then fill in argon as the protection gas, heat the furnace up to a temperature beyond the melting point of silicon to melt the raw materials in the crucible, keep the temperature so that the temperature and flow state of liquid silicone become stable and the distribution of gallium become even, then conduct crystal growth to get mono-crystalline silicon rods. In the above processes, said crystal growth includes inserting seed crystal, dash process to form the crystal neck, forming crystal shoulder to get the diameter you need, growing the crystal with a constant diameter, forming the end cone and so on, which is as the same as the conventional method. Then cut the bar for processing and inspection to get mono-crystalline silicon wafer.

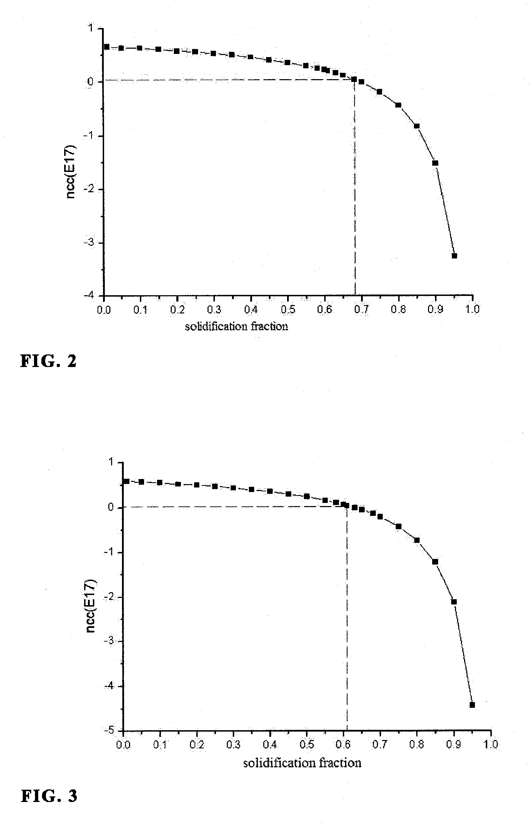

In this example, the concentrations of boron and phosphorus contained in the silicon wafer obtained above are 4.15 ppma and 6.08 ppma respectively. We can see from FIG. 2, after the above treatment, the length of utilized silicon rod is 68%.

The silicon wafer made according to this Example can be made into mono-crystalline silicon solar cells with normal process. Tests show that these solar cells have an average photoelectric conversion efficiency of 14.5%.

### Comparison Example 1:

Using the poly-crystalline silicon with the same low purity as that used in Example 1, treating it with the same process as in Example 1 but not having gallium added, to get the mono-crystalline silicon wafer.

Refer to FIG. 3 that, using the same technology but not having gallium added, the length of utilized silicon rod is 61%.

Clearly, the length of utilized silicon rod in Example 1 is 7% more than that in the Comparison Example 1.

### Example 2:

A process for manufacturing silicon wafers for solar cell, first break the refined metallurgical silicon to the appropriate size, then after preliminary selection to remove visible impurities, put them into ultrasonic cleaner for cleaning, move into mixture of nitric acid and hydrofluoric acid in order to wash away the surface impurities; and then put them into high-purity quartz crucible, and add gallium with atomic concentration of 12.2 ppma, put quartz crystal crucible into a heat exchanging platform (polycrystalline growing furnace), and then pump the furnace to 0.05∼0.1mbar pressure , fill in argon as the protection gas, keep a pressure of 400∼600mbar in the furnace; heat the furnace slowly up to 1200∼1300°C which requires a duration of 4 to 5 hours; increase the heating power gradually up to 1500°C until the silicon materials begin to melt, keep this temperature until the melting is finished which requires a duration of 9 to 12 hours, reduce the heating power till the temperature is close to the melting point of silicon, then move the quartz crucible gradually down or move the heat insulation device gradually up so that the temperature goes down from the bottom of melted material to the top of it; the crystal silicon will form from the bottom and grows up in a column shape, and during the growing process, the interface of solid and liquid should be kept as horizontal as possible until the whole growing process is completed which requires a duration of 20 to 22 hours; keep the temperature close to the melting point of silicon for 2 to 4 hours as annealing, and finally cool it down and let in argon to the furnace until it reaches normal atmospheric pressure, and thus we get the poly-crystalline silicon bar. Cut the bar for processing and inspection to get poly-crystalline silicon wafer.

The concentrations of boron and phosphorus contained in the silicon wafer obtained above are 4.21 ppma and 6.17 ppma respectively. After the above treatment, the length of utilized silicon rod is 67%.

The silicon wafer made according to this Example can be made into polycrystalline silicon solar cells with normal process. Tests show that these solar cells have an average photoelectric conversion efficiency of 13.6%.

According to the contents of phosphorus, we may also add GaP into the raw material of silicon instead of Ga.

### Comparison Example 2:

Using the polycrystalline silicon with the same low purity as that used in Example 2, treating it with the same process as in Example 2 but not having gallium added, to get the poly-crystalline silicon wafer.

The result shows that as gallium is not added in, even though there are processes of acid cleaning and oriented crystallization to make the impurity tend to keep in a zone, yet the length of utilized silicon rod is 61 % when it is used to make solar cells.

In addition, the polycrystalline silicon solar cells manufactured with the poly-crystalline silicon wafer obtained in this comparison example, have a photoelectric conversion efficiency of 13.4% on average.

It shows that the length of utilized silicon rod in Example 2 is 6% more than that in the Comparison Example 2.

## Claims

1. A process for manufacturing silicon wafers for solar cell, first break the refined metallurgical silicon, remove visible impurities, do chemical cleaning and then put them into crystal growing furnace, do subdivision and inspection after the crystal rods or crystal bars have grown, thus get the silicon wafers needed, which comprises: when putting the silicon into the furnace, adding gallium or gallium phosphide to the raw materials of silicon where the concentration of gallium atoms should be in the range from 5 ppma to 14 ppma.

2. The process according to claim 1, wherein said crystal rods growth is pulling of silicon crystals process and the wafer obtained is mono-crystalline silicon wafer.

3. The process according to claim 1, wherein said crystal rods growth is polycrystalline silicon casting process and the wafer obtained is polycrystalline silicon wafer.
